# EUROPEAN PATENT APPLICATION

(11) **EP 3 312 874 A1**
(43) Date of publication of application: **25.04.2018**
(21) Application number: 16194866.6
(22) Date of filing: 20.10.2016
(51) Int. Cl.: H01L 21/768, H01L 23/48

(54) **METHOD OF FORMING A THROUGH-SUBSTRATE VIA AND A SEMICONDUCTOR DEVICE COMPRISING A THROUGH-SUBSTRATE VIA**

(71) Applicant: ams AG, 8141 Unterpremstätten (AT)
(72) Inventor: Kraft, Jochen, 8600 Bruck an der Mur (AT); Parteder, Georg, 8200 Gleisdorf (AT); Jessenig, Stefan, 8010 Graz (AT); Schrank, Franz, 8052 Graz (AT)
(74) Representative: Epping - Hermann - Fischer

(57) **Abstract**

The method of forming a through-substrate via comprises providing a substrate (1) with a dielectric (2) arranged on the substrate (1) and with a metal layer (3) embedded in the dielectric (2), forming a via hole (9) penetrating the substrate (1), removing the dielectric (2) from above the metal layer (3), so that the via hole (9) reaches the metal layer (3), and a contact area (10) of the metal layer (3) is exposed inside the via hole (9), applying an insulation layer (11) in the via hole (9), removing the insulation layer (11) from above the metal layer (3), and applying a metallization (12) in the via hole (9), the metallization (12) contacting a contact area (10) of the metal layer (3) and being insulated from the substrate (1) by the insulation layer (11).

## Description

A through-substrate via is an electric interconnection through a semiconductor substrate. It comprises a via hole penetrating the substrate and a metallization arranged in the via hole.

A through-substrate via can be produced by first forming a metal layer in a dielectric material above a main surface of the substrate. Layers of a different metallic material covering the metal layer improve the adhesion of the dielectric material. Then a via hole is etched from the opposite surface through the substrate, until the dielectric material is reached. A silicon oxide layer, which is provided as an insulation, is arranged on the sidewall and the bottom of the via hole. The silicon oxide and the dielectric material are removed from the bottom of the via hole by an anisotropic etching step, so that the silicon oxide remains on the sidewall to cover the semiconductor material, and a contact area of the metal layer is exposed at the bottom. A metallization is applied in the via hole, so that it contacts the metal layer and forms the electric interconnection.

WO 2010/006916 A1 discloses a method of producing a semiconductor component comprising a through-substrate via. A connection pad is arranged in the insulation layer of an SOI substrate. A via hole is formed above the connection pad. The semiconductor material that is exposed at the sidewall of the via hole is provided with an insulation. A metallization is arranged on the insulation and is electrically connected to the connection pad. The metallization is contacted on the upper surface, outside the via hole, with a top metal layer.

US 2011/0237073 A1 discloses a method of forming a through silicon via. A polymer is formed in the via opening. A first wet clean removes a first portion of the polymer and forms a first carbon containing oxide along portions of the sidewalls. A first ash process modifies the first carbon containing oxide and removes a second portion of the polymer. A first wet etch removes the modified first carbon containing oxide and a third portion of the polymer. A second ash process forms a second carbon containing oxide along at least a portion of the sidewalls. A second wet etch process removes the second carbon containing oxide and a fourth portions of the polymer. A third ash process forms a third carbon containing oxide along portions of the sidewalls and removes any remaining portions of the polymer.

It is an object of the present invention to provide a method of forming a through-substrate via that improves the application of the steps of etching and insulating and a semiconductor device comprising a through-substrate via reliably contacting a metal layer that is adherently embedded in an intermetal dielectric.

This object is achieved with the method of forming a through-substrate via according to claim 1 and the semiconductor device according to claim 12. Variants of the method and further embodiments derive from the dependent claims.

The method of forming a through-substrate via comprises providing a substrate with a dielectric arranged on the substrate and with a metal layer embedded in the dielectric, forming a via hole penetrating the substrate, removing the dielectric from above the metal layer, so that the via hole reaches the metal layer, and a contact area of the metal layer is exposed inside the via hole, applying an insulation layer in the via hole, removing the insulation layer from above the metal layer, and applying a metallization in the via hole, the metallization contacting a contact area of the metal layer and being insulated from the substrate by the insulation layer. The metal layer may especially be aluminum.

In a variant of the method, a further metal layer is arranged on the metal layer, the further metal layer facing the substrate, the metal layer comprising a metal that is different from the metal of the further metal layer.

In a further variant, the further metal layer comprises titanium. The further metal layer may especially be titanium nitride.

In a further variant, the dielectric is removed from above the metal layer by etching and by using a recipe that is non-selective with respect to the further metal layer.

In a further variant, the dielectric and the insulation layer are removed from above the metal layer by etching, and in each of these etching steps a recipe is used that only causes low polymerization. In particular, the same recipe can be used in each of these etching steps.

In a further variant, a mask with an opening is applied, and the via hole is etched through the opening. The mask may be a resist mask or a hardmask. The mask is optionally removed before the insulation layer is applied.

The semiconductor device comprises a substrate with a through-substrate via, a via hole of the through-substrate via, an insulation layer in the via hole, a metallization of the through-substrate via, an insulation layer insulating the metallization from the substrate, and a metal layer above the substrate, the metallization contacting the metal layer. A further metal layer is arranged on the metal layer, the further metal layer facing the substrate. The further metal layer comprises a metal that is different from the metal of the metal layer. The metallization is completely separated from the further metal layer by the insulation layer.

In embodiments of the device, the further metal layer comprises titanium, in particular titanium nitride.

The following is a detailed description of examples of the method and the device in conjunction with the appended figures.
- Figure 1: is a cross section of an intermediate product before the via hole is etched.
- Figure 2: is a cross section according to Figure 1 after the via hole is etched.
- Figure 3: is a cross section according to Figure 2 after an application of an insulation layer.
- Figure 4: is a cross section according to Figure 3 after the insulation layer is removed from the bottom of the via hole.
- Figure 5: is a cross section according to Figure 4 after an application of a metallization.
- Figure 6: is a cross section according to Figure 5 after an application of a top metal.

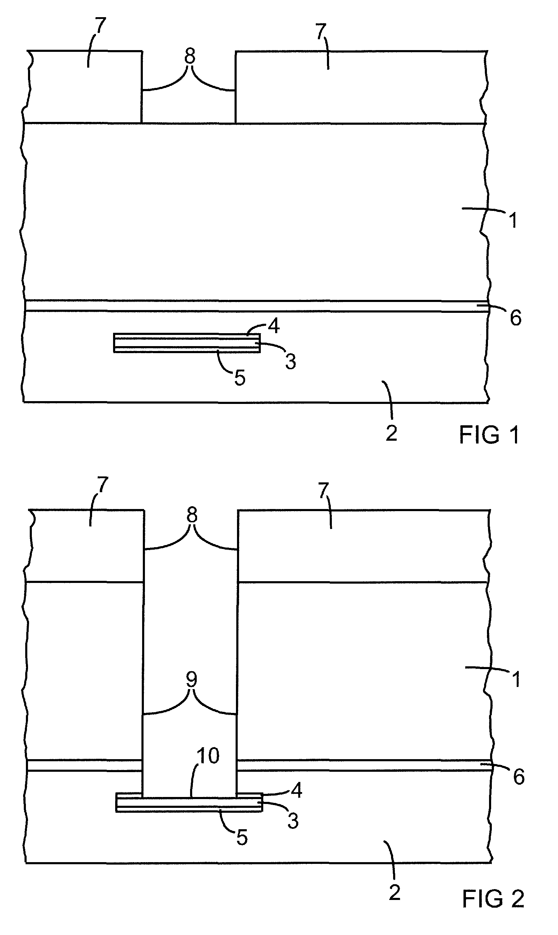

Figure 1 is a cross section of an example of an intermediate product that may be obtained with the method. A substrate 1 of semiconductor material like silicon, for instance, is provided with a dielectric 2, which may especially be an intermetal dielectric like silicon oxide, for instance. A further dielectric 6, which is different from the dielectric 2, may optionally be arranged between the substrate 1 and the dielectric.

A metal layer 3 is embedded in the dielectric 2. The metal layer 3 may especially be part of a wiring, which may comprise several metal layers, for instance. Details of such a wiring, which is known per se from CMOS technology, are not relevant to the invention and are not represented in the figures. The metal layer 3 may especially be aluminum, for example.

The opposite main surfaces of the metal layer 3 may be provided with a further metal layer 4 facing the substrate 1, and/or with an opposite metal layer 5 facing away from the substrate 1. The further metal layer 4 and/or the opposite metal layer 5 may especially comprise titanium. In particular, the further metal layer 4 and/or the opposite metal layer 5 may be titanium nitride. Metal layers of a wiring, which are embedded in an intermetal dielectric, are conventionally provided with coverings of titanium nitride, in particular in CMOS technology, in order to enhance the adhesion of the dielectric material to the metal layers. The metal layer 3, the further metal layer 4 and the opposite metal layer 5 may be applied as part of such a wiring.

A mask 7, which may be a resist mask or a hardmask, for instance, is applied on the backside of the substrate 1, opposite the dielectric 2. The mask 7 has an opening 8 opposite the metal layer 3 and above the region where the through-substrate via is to be formed.

Figure 2 is a cross section according to Figure 1 and shows a further intermediate product after the formation of a via hole 9. The via hole 9 is etched in the substrate 1 through the opening 8 of the mask 7. It is an essential feature of the method that etching is continued through the dielectric 2, 6 until the metal layer 3 or the further metal layer 4 is reached. The mask 7 is still present while the dielectric 2, 6 is etched. Owing to a modification of the chemical environment by the material of the mask 7, polymers that are formed in the course of the etching process may be more easily removed while the mask 7 is still present.

The further metal layer 4 may be used as an etch stop layer terminating the etching of the dielectric 2, 6, but this is not necessary in this method. Instead, the etching can be continued into the further metal layer 4. This means that the etching process need not be selective with respect to the material of the further metal layer 4. Hence the etching recipe can be selected in view of low polymerization. In any case the further metal layer 4 is removed from the bottom of the via hole 9 in order to expose a contact area 10 of the surface of the metal layer 3. Some material of the metal layer 3 may also be removed in this step without adversely affecting the further process steps and, in particular, the electric contact that is later formed on the metal layer 3.

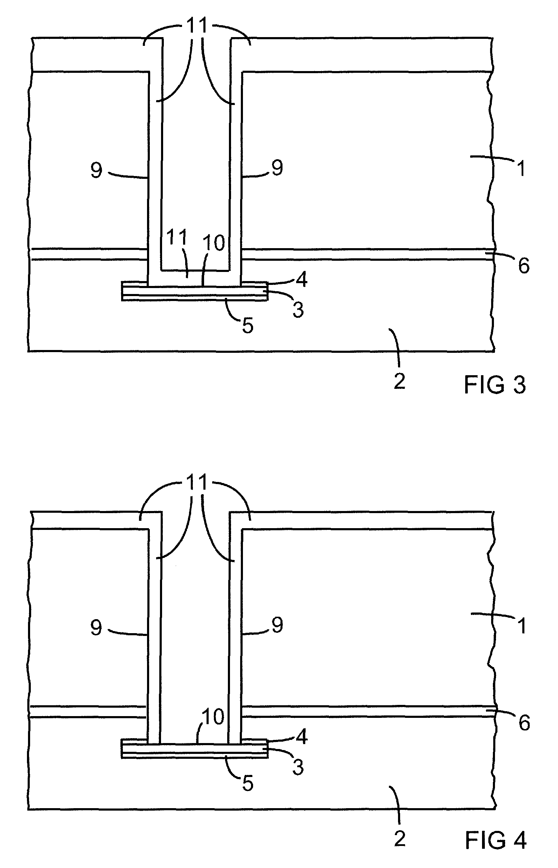

Figure 3 is a cross section according to Figure 2 and shows a further intermediate product after an application of an insulation layer 11. The insulation layer 11, which may be silicon oxide, for instance, is provided as an insulation between the semiconductor material of the substrate 1 and the metallization that will later be applied to form the electrically conductive part of the through-substrate via. The insulation layer 11 may be applied by deposition, for example. Portions of the insulation layer 11 typically also cover the contact area 10 of the metal layer 3 and the backside of the substrate 1 outside the via hole 9.

Figure 4 is a cross section according to Figure 3 and shows a further intermediate product after a partial removal of the insulation layer 11. An anisotropic etching process, which is also known per se from the etching of spacers, is applied to remove the insulation layer 11 from the bottom of the via hole 9, so that the contact area 10 of the metal layer 3 is again exposed. The etching recipe can again be selected in view of low polymerization. The portion of the insulation layer 11 that is applied outside the via hole 9 may be completely removed. Instead, as shown in Figure 4 by way of example, the backside of the substrate 1 may still be covered by the insulation layer 11.

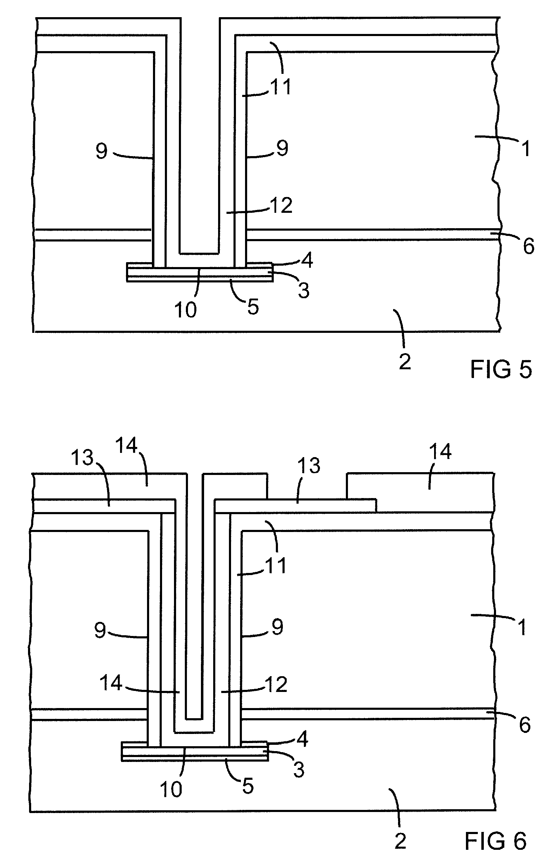

Figure 5 is a cross section according to Figure 4 and shows a further intermediate product after an application of a metallization 12, which is provided for the electrically conductive part of the through-substrate via. The metallization 12 can be applied as a layer, especially a conformal layer. It is applied on the contact area 10 of the metal layer 3, so that it is in electric contact with the contact area 10. Thus an electric connection is formed from the metal layer 3 to the backside of the substrate 1. The metallization 12 may comprise more than one metal and may especially be applied as a sequence of metal layers, which may include titanium and tungsten layers, for instance. The metallization 12 is separated from the remaining portion of the further metal layer 4 by the bottom of the insulation layer 11.

Figure 6 is a cross section according to Figure 5 after further process steps. The metallization 12 is optionally removed from the backside of the substrate 1, and a top metal 13 may be applied on the backside and in contact with the metallization 12. In this way a redistribution layer, for example, may be formed on the backside. The top metal 13 may be covered with a cover layer 14, which may be a further dielectric, for instance. At least one opening in the cover layer 14 may provide access to the top metal 13 for the purpose of applying a bump contact, for example, or a similar external electric terminal. Details of the electric conductors that may be formed on the backside are not relevant to the invention and are not shown in Figure 6.

The method has the advantage that the metal layer 3 is used as an etch stop layer before the insulation layer 11 is applied. As the further metal layer 4 is removed from the contact area 10, there is no risk that the further metal layer 4 becomes porous during a wet cleaning step, which is required after etching, and thus allows the cleaning agent to penetrate and attack the surface of the metal layer 3. The described method yields a contact area 10 that is sufficiently smooth for the metallization 12 to be applied, even if the further metal layer 4 is made as thin as desired for a wiring of a CMOS device, for example. The etching of the dielectric 2, 6 and the etching of the insulation layer 11 can separately be optimized. The etching recipe can be selected for low polymerization to facilitate indispensable cleaning steps.

### List of reference numerals

- 1: substrate
- 2: dielectric
- 3: metal layer
- 4: further metal layer
- 5: opposite metal layer
- 6: further dielectric
- 7: mask
- 8: opening
- 9: via hole
- 10: contact area
- 11: insulation layer
- 12: metallization
- 13: top metal
- 14: cover layer

## Claims

1. A method of forming a through-substrate via, comprising:
- providing a substrate (1) with a dielectric (2) arranged on the substrate (1) and with a metal layer (3) embedded in the dielectric (2),
- forming a via hole (9) penetrating the substrate (1),
- applying an insulation layer (11) in the via hole (9),
- removing the insulation layer (11) from above the metal layer (3), and
- applying a metallization (12) in the via hole (9), the metallization (12) contacting the metal layer (3) and being insulated from the substrate (1) by the insulation layer (11),
**characterized in that**
- before the insulation layer (11) is applied, the dielectric (2) is removed from above the metal layer (3), so that the via hole (9) reaches the metal layer (3), and a contact area (10) of the metal layer (3) is exposed inside the via hole (9), and
- after the insulation layer (11) is removed from above the metal layer (3), the metallization (12) is applied in electric contact with the contact area (10).

2. The method of claim 1, further comprising:
arranging a further metal layer (4) on the metal layer (3), the further metal layer (4) facing the substrate (1), the metal layer (3) comprising a metal that is different from the metal of the further metal layer (4).

3. The method of claim 2, wherein the further metal layer (4) comprises titanium.

4. The method of claim 3, wherein the further metal layer (4) is titanium nitride.

5. The method of one of claims 2 to 4, wherein the dielectric (2) is removed from above the metal layer (3) by etching and by using a recipe that is non-selective with respect to the further metal layer (4).

6. The method of one of claims 1 to 5, wherein the metal layer (3) is aluminum.

7. The method of one of claims 1 to 6, wherein the dielectric (2) and the insulation layer (11) are removed from above the metal layer (3) by etching, and in each of these etching steps the same etching recipe is used.

8. The method of one of claims 1 to 7, further comprising:
before forming the via hole (9), applying a mask (7) with an opening (8), and
etching the via hole (9) through the opening (8).

9. The method of claim 8, wherein the mask (7) is removed before the insulation layer (11) is applied.

10. The method of claim 8 or 9, wherein the mask (7) is a resist mask.

11. The method of claim 8 or 9, wherein the mask (7) is a hardmask.

12. A semiconductor device, comprising:
- a substrate (1) with a through-substrate via,
- a via hole (9) of the through-substrate via,
- an insulation layer (11) in the via hole (9),
- a metallization (12) of the through-substrate via,
- an insulation layer (11) insulating the metallization (12) from the substrate (1), and
- a metal layer (3) above the substrate (1), the metallization (12) contacting the metal layer (3),
**characterized in that**
- a further metal layer (4) is arranged on the metal layer (3), the further metal layer (4) facing the substrate (1),
- the further metal layer (4) comprises a metal that is different from the metal of the metal layer (3), and
- the metallization (12) is completely separated from the further metal layer (4) by the insulation layer (11).

13. The semiconductor device according to claim 12, wherein the further metal layer (4) comprises titanium.

14. The semiconductor device according to claim 13, wherein the further metal layer (4) is titanium nitride.
